# EUROPEAN PATENT APPLICATION

(11) **EP 4 468 689 A1**
(43) Date of publication of application: **27.11.2024**
(21) Application number: 22919988.0
(22) Date of filing: 09.12.2022
(51) Int. Cl.: H04M 1/02, C03C 15/00

(54) **FLASH GLASS AND PREPARATION METHOD THEREFOR, AND ELECTRONIC DEVICE HOUSING**

(30) Priority: 17.01.2022 CN 202210049208
(71) Applicant: BYD Company Limited, Shenzhen, Guangdong 518118 (CN)
(72) Inventor: YANG, Jingjie, Shenzhen Guangdong 518118 (CN); LUO, Fuhua, Shenzhen Guangdong 518118 (CN); YUAN, Tao, Shenzhen Guangdong 518118 (CN); MA, Lan, Shenzhen Guangdong 518118 (CN)
(74) Representative: Gulde & Partner
(86) International application number: PCT/CN2022/137990
(87) International publication number: WO 2023/134355

(57) **Abstract**

Flashed glass is provided, which includes a glass body (10). A first surface (10a) of the glass body (10) includes multiple first frosted regions (101) distributed spaced away. Two adjacent first frosted regions (101) are connected by a second frosted region (102), and the first frosted regions (101) and the second frosted region (102) are straight strip-shaped. Each of the first frosted regions (101) has multiple first protruding structures (11). The second frosted region (102) has multiple second protruding structures (12). Each of the first protruding structures (11) and each of the second protruding structures (12) respectively include at least one edge. A height and a length of the second protruding structure (12) are both less than a height and a length of the first protruding structure (11). A method for preparing flashed glass and an electronic device housing including the flashed glass are further provided.

## Description

### CROSS-REFERENCE TO RELATED APPLICATIONS

The present disclosure claims priority to Chinese Patent Application No. 202210049208.7, filed on January 17, 2022 and entitled "FLASHED GLASS AND PREPARING METHOD THEREOF, AND ELECTRONIC DEVICE HOUSING". The entire content of the above-referenced application is incorporated herein by reference.

### FIELD

The present disclosure relates to the field of glass processing technologies, and more specifically, to flashed glass and a preparing method thereof, and an electronic device housing.

### BACKGROUND

With the continuous development of electronic devices such as a mobile phone and a notebook computer, users have increasingly high requirements for an appearance effect of an electronic device housing. Glass is a commonly used housing material for the electronic device, which may be used as a cover plate and a back plate, for example. However, the glass currently on the market has a relatively monotonous appearance, which cannot satisfy diversified aesthetic needs of the users and has weak product competitiveness.

### SUMMARY

The present disclosure provides flashed glass, which may present multiple flashing effects with different flash degrees, and can improve appearance expression of an electronic device housing using the flashed glass and enhance product competitiveness.

Specifically, according to a first aspect, the present disclosure provides flashed glass, which includes a glass body. The glass body includes a first surface having a texture. The first surface includes multiple first frosted regions distributed spaced away. Two adjacent first frosted regions are connected by a second frosted region. The first frosted regions and the second frosted region are straight strip-shaped. Each of the first frosted regions has multiple first protruding structures. The second frosted region has multiple second protruding structures. Each of the first protruding structures and each of the second protruding structures respectively include at least one edge. A height and a length of the second protruding structure are both less than a height and a length of the first protruding structure.

The first surface of the foregoing flashed glass has a frosting effect, and is provided with two straight strip-shaped frosted regions arranged alternately. The protruding structures forming the two frosted regions have different heights and lengths. When a light ray irradiates the first surface of the flashed glass, two protruding structures having the at least one edge may reflect light toward different directions, thereby producing a sparkling appearance effect. In addition, multiple flashing effects with different flash degrees may be presented, which greatly improves the appearance effect.

According to a second aspect, the present disclosure provides a method for preparing flashed glass, which includes the following steps.

First etching-by-frosting is performed on a first surface of a glass body, to cause multiple first protruding structures to be formed on the first surface. Each of the first protruding structures includes at least one edge.

Multiple photoresist patterns in parallel and distributed spaced away are formed on the first surface after the first etching-by-frosting. The photoresist patterns are long strip-shaped.

Second etching-by-frosting is performed on the first surface with the photoresist patterns, to cause the first surface not covered by the photoresist patterns to be transformed into a second frosted region having multiple second protruding structures. Then the photoresist patterns are removed. A first frosted region having the multiple first protruding structures on a surface is obtained between adjacent second frosted regions. Each of the second protruding structures includes at least one edge. A height and a length of the second protruding structure are both less than a height and a length of the first protruding structure.

The foregoing method for preparing flashed glass is simple to operate. The flashed glass obtained by the method has a frosting effect, and may present multiple flashing effects with different flash degrees under the light, which improves a visual perception of a user.

According to a third aspect, the present disclosure provides an electronic device housing, which includes the flashed glass in the first aspect of the present disclosure, or the flashed glass made by the preparing method in the second aspect of the present disclosure.

The electronic device housing including the foregoing flashed glass has a cool appearance effect, which can improve the appearance expression of the electronic device and the product competitiveness.

### BRIEF DESCRIPTION OF THE DRAWINGS

FIG. 1 is a metallographic microscope photo of flashed glass according to an embodiment of the present disclosure.
FIG. 2 is a schematic diagram of a cross-sectional structure of flashed glass according to an implementation of the present disclosure.
FIG. 3 is a flowchart of preparing flashed glass according to an embodiment of the present disclosure.
FIG. 4 is a metallographic microscope photo of a glass body after first etching-by-frosting according to Embodiment 1 of the present disclosure.
FIG. 5 is a metallographic microscope photo in which photoresist patterns are formed on a surface of the glass body in FIG. 4.
FIG. 6 is a metallographic microscope photo of flashed glass obtained after second etching-by-frosting of the glass body in FIG. 5.
FIG. 7 is an appearance effect diagram of flashed glass according to Embodiment 1 of the present disclosure.
FIG. 8 is an appearance effect diagram of the glass body in FIG. 4.
FIG. 9 is an appearance effect diagram of flashed glass according to Embodiment 5 of the present disclosure.

### DETAILED DESCRIPTION

The following are exemplary implementations of the present disclosure. It is to be noted that a person of ordinary skill in the art may further make several improvements and refinements without departing from the principles of the present disclosure. These improvements and refinements shall fall within the protection scope of the present disclosure.

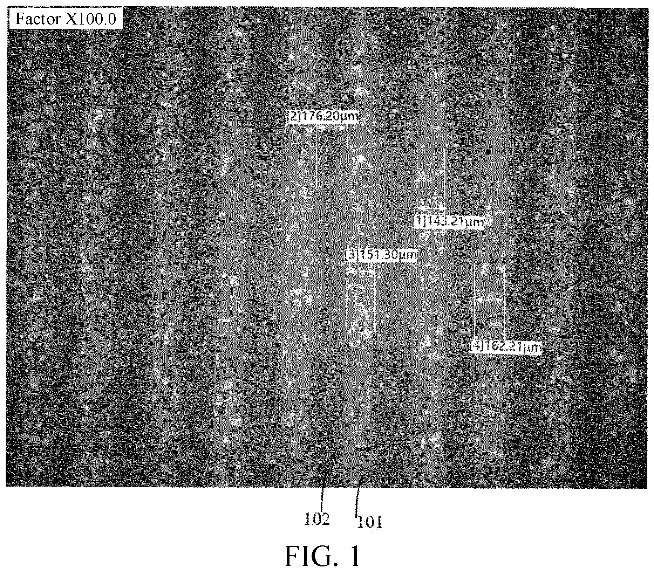

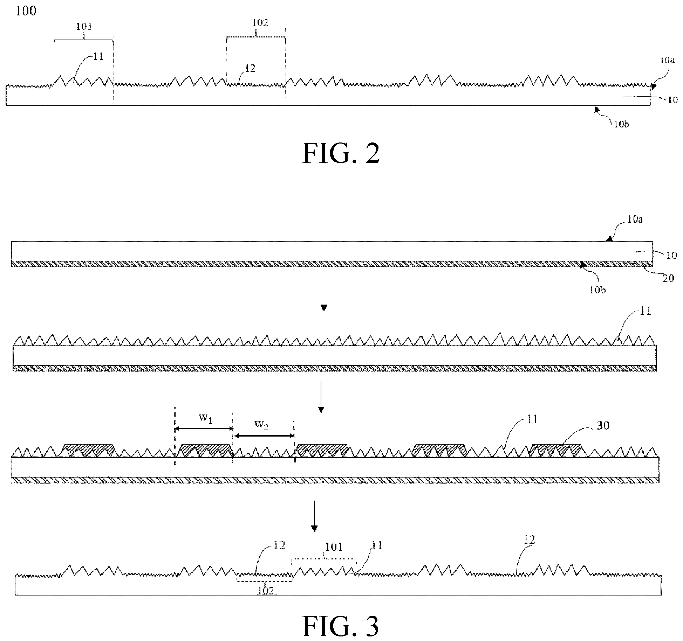

FIG. 1 is a metallographic microscope photo of flashed glass according to an embodiment of the present disclosure. FIG. 2 is a schematic diagram of a cross-sectional structure of flashed glass according to an implementation of the present disclosure. Referring to FIG. 1 and FIG. 2 together, flashed glass 100 provided in this embodiment of the present disclosure includes a glass body 10. The glass body 10 is provided with a first surface 10a. The first surface 10a includes multiple first frosted regions 101 distributed spaced away. Two adjacent first frosted regions 101 are connected by a second frosted region 102. The first frosted regions 101 and the second frosted region 102 are straight strip-shaped. Each of the first frosted regions 101 has multiple first protruding structures 11. The second frosted region 102 has multiple second protruding structures 12. Each of the first protruding structures 11 and each of the second protruding structures 12 respectively include at least one edge. A height and a length of the second protruding structure 12 are both less than a height and a length of the first protruding structure 11. In the present disclosure, the first protruding structure may be referred to as a "large protrusion", and the second protruding structure may be referred to as a "small protrusion".

The first surface 10a of the foregoing flashed glass is provided with two straight strip-shaped frosted regions arranged alternately. The protruding structures forming the two frosted regions have different heights and lengths. The first surface has a frosting effect, and when a light ray irradiates the first surface of the flashed glass, the two protruding structure having the at least one edge may reflect light irradiating a side surface of each edge. Due to different angles of the side surfaces of each edge, reflected light in different directions may be generated, thereby generating a sparkling appearance effect. With a composite superposition of the reflected light on the two protruding structures, multiple flashing effects with different flash degrees may be presented, which improves the multi-layered and dynamic flashing effect, enriches a visual effect of the flashed glass, and enhances the aesthetic appearance. In addition, the alternate arrangement of the first frosted regions 101 with the multiple first protruding structures 11 and the second frosted regions 102 with the multiple straight strip-shaped second protruding structures 12 may enhance a decorative effect of glass and improve market application prospects of the flashed glass. Moreover, the arrangement of the multiple first protruding structures 11 and the multiple second protruding structures 12 may also reduce a contact area between a human finger and a glass surface, increase an anti-fingerprint effect, enhance a diffuse reflection effect of the glass, and enhance an anti-glare effect.

In the present disclosure, the first surface 10a forms flash points at the first protruding structure 11 and the second protruding structure 12 under the irradiation of the light. Specifically, the flash point is formed on the side surface of the edge of each protruding structure.

That "the protruding structure includes at least one edge" in the present disclosure means that the protruding structure includes at least two surfaces that have different directions and intersect, and the edge is formed at a position in which the two surfaces intersect (or are connected). The protruding structure has a diamond-like shape, and can effectively generate specular reflection, thereby achieving a sparkling appearance effect. Specifically, a shape of the protruding structure having at least one edge includes, but is not limited to, a prism (such as a triangular prism, a quadrilateral prism, a pentagonal prism, and a hexagonal prism), a pyramidal frustum (such as a triangular pyramidal frustum, a square pyramidal frustum, and a pentagonal pyramidal frustum), a cube, a pyramid (such as a triangular pyramid and a quadrilateral pyramid), a similar structure thereof, or the like. In some implementations of the present disclosure, the shapes of the first protruding structure 11 and the second protruding structure 12 each include the prism, the pyramidal frustum, and the like, and may specifically include the triangular prism, the triangular pyramidal frustum, and the like.

In an implementation of the present disclosure, morphologies of the first protruding structure 11 and the second protruding structure 12 each belong to at least one of a crystal morphology of a hexagonal system, a crystal morphology of a cubic system, a crystal morphology of a trigonal system, a crystal morphology of a tetragonal system, and a crystal morphology of an orthorhombic system. The protruding structures having the foregoing crystal morphologies have improved flashing effects under an illumination condition and is conducive to improving the aesthetic appearance. The cubic system is also referred to as an isometric system. The orthorhombic system is also referred to as an "orthorhombic system". It is to be noted that, that "the morphology of the protruding structure belongs to at least one of the crystal morphology of the hexagonal system, the crystal morphology of the cubic system, the crystal morphology of the trigonal system, the crystal morphology of the tetragonal system, and the crystal morphology of the orthorhombic system" described above should be understood in a broad sense. To be specific, the morphology of the protruding structure is not necessarily consistent with the crystal morphology of the hexagonal system, the crystal morphology of the cubic system, the crystal morphology of the trigonal system, and the crystal morphology of the tetragonal system. A specific deviation is allowed as long as the morphology of the protruding structure is substantially consistent with the foregoing crystal morphology of the system.

It may be understood that at least one surface of the glass body 10 is provided with the first frosted region 101 and the second frosted region 102. Still referring to FIG. 1, the glass body 10 is provided with the first surface 10a and a second surface 10b oppositely arranged. In FIG. 1, an example in which the first surface 10a is provided with the first frosted region 101 and the second frosted region 102 is used. However, it may be understood that the second surface 10b may be provided with the first frosted region 101 and the second frosted region 102, or may not be provided with the first frosted region 101 and the second frosted region 102, which is not limited. In addition, "first" and "second" in the present disclosure are used for the purpose of description only.

In the present disclosure, the height of the first protruding structure 11 is greater than the height of the second protruding structure 12, and the length of the first protruding structure 11 is greater than the length of the second protruding structure 12. In an implementation of the present disclosure, the length of the first protruding structure 11 may be in a range of 100 µm to 150 µm. The height of the first protruding structure 11 may be in a range of 10 µm to 16 µm. In an implementation of the present disclosure, the length of the second protruding structure 12 may be in a range of 30 µm to 60 µm. The height of the second protruding structure 12 may be in a range of 3 µm to 6 µm.

The length of the first protruding structure 11 is controlled within the foregoing range, which may cause a section thereof to have a diamond-like protruding shape and have excellent reflection and diffuse reflection effects, and the first frosted region can have a good frosting sense of touch. The height of the first protruding structure 11 is controlled within the foregoing range, to enable the first protruding structure 11 to have a suitable stereoscopic effect and the first frosted region to have an improved appearance effect, and enhance the anti-fingerprint effect and the anti-glare effect. In addition, it may be ensured that holding comfort is not affected. In an implementation of the present disclosure, a length-height ratio of the first protruding structure 11 is in a range of 6 to 15. In some implementations, the length-height ratio is in a range of 8 to 15.

The length and the height of the second protruding structure 12 are controlled to be within the foregoing range, which may facilitate differentiation from the first protruding structure 11, to ensure that the flashing effect of glass may be enriched by two different protruding structures. The length of the second protruding structure 12 also ensures that the second frosted region has a relatively large number of second protruding structures that are closely arranged. A flash point on the glass surface has a high brightness and a delicate flashing effect, which may also improve the anti-fingerprint effect. A small range of the height may ensure high uniformity of the morphologies of the second protruding structure 12 and uniformity of the flashing effects brought by the second protruding structure 12. In an implementation of the present disclosure, a length-height ratio of the second protruding structure 12 is in a range of 5 to 20. In this case, a change in the height does not excessively affect the morphology uniformity of the second protruding structure 11. In some implementations, the length-height ratio is in a range of 6 to 15, and may specifically be in a range of 6 to 10.

The length of the first protruding structure 11 is a maximum spacing between any two points on a contour line of an orthographic projection of the first protruding structure on the second surface 10b. The height of the first protruding structure 11 is a distance between a top end of the first protruding structure and a top portion thereof. Specifically, the length of the first protruding structure 11 may be 105 µm, 110 µm, 115 µm, 120 µm, 130 µm, 140 µm, 145 µm, 150 µm, or the like. The height of the first protruding structure 11 may be 10 µm, 11 µm, 12 µm, 13 µm, 14 µm, 15 µm, 16 µm, or the like.

Similarly, the length of the second protruding structure 12 is a maximum spacing between any two points on a contour line of an orthographic projection of the second protruding structure on the second surface 10b. The height of the second protruding structure 12 is a distance between a top end of the second protruding structure and a top portion thereof. Specifically, the length of the second protruding structure 12 may be 32 µm, 40 µm, 45 µm, 50 µm, 55 µm, 60 µm, or the like. The height of the second protruding structure 12 may be 3 µm, 3.5 µm, 4 µm, 5 µm, 5.5 µm, 6 µm, or the like.

In the present disclosure, adjacent first protruding structures 11 or adjacent second protruding structures 12 may be seamlessly connected (that is, adjacent), or may be defined with a specific spacing. In an implementation of the present disclosure, the adj acent first protruding structures 11 are adjacent to each other, and the adjacent second protruding structures 12 are adjacent to each other. In this way, an abundant flashing effect and a favorable sense of holding of the first surface with the first frosted region 101 and the second frosted region 102 can be ensured.

In an implementation of the present disclosure, a width of the first frosted region 101 ranges from 100 µm to 500 µm. A width of the second frosted region 102 ranges from 100 µm to 500 µm. The first frosted regions 101 are arranged in parallel along a first direction, or the first frosted regions 101 extend along the first direction. The first direction may be a length direction, a width direction, or another linear direction of the glass body 10. In this case, the width of the first frosted region 101 is a size of an orthographic projection of the first frosted region on the second surface 10b along a direction perpendicular to the first direction. The width of the second frosted region 102 is defined similarly. It may be understood that the width of the second frosted region 102 is an interval between two adjacent first frosted regions 101, and the width of the first frosted region 101 is an interval between two adjacent second frosted regions 102. Since the height and the length of the foregoing first protruding structure 11 are both greater than the height and the length of the second protruding structure 12, correspondingly, the first frosted region may be referred to as a "protrusion region" and the second frosted region may be referred to as a "recessed region". The width of the first frosted region 101 may be equal to or different from the width of the second frosted region 102.

The width of the first frosted region 101 and the width of the second frosted region 102 are controlled to be within the foregoing range, which may separate the two frosted regions, ensure a relatively large number of corresponding protruding structures of the two frosted regions, may further ensure that the flashed glass has the abundant flashing effect and the anti-glare effect, and can provide a better stereoscopic effect, sense of holding, anti-fingerprint effect, and the like. In some embodiments, the width of the first frosted region 101 and the width of the second frosted region 102 are each 100 µm, 110 µm, 130 µm, 140 µm, 150 µm, 200 µm, 250 µm, 300 µm, 400 µm, 450 µm, 500 µm, or the like.

In an implementation of the present disclosure, a haze of the second frosted region is greater than a haze of the first frosted region. In some implementations of the present disclosure, the haze of the first frosted region 101 may be in a range of 80% to 90%, and a light transmittance thereof may be in a range of 75% to 93%. The haze of the second frosted region 102 may be in a range of 90% to 95%, and a light transmittance thereof may be in a range of 75% to 93%.

When the hazes of the two frosted regions are within the foregoing range, the glass can produce a hazy visual effect, improve the aesthetic sense, can achieve a good anti-glare and anti-fingerprint effect, and also has a sparkling appearance effect, so that the flashed glass can provide a strong visual impact. When the light transmittances of the two frosted regions are within the foregoing range, respective light transmittances are enhanced, transparency is improved, and appearance expression is enhanced when the frosted regions have frosted effects.

In some implementations of the present disclosure, the light transmittances of the first frosted region 101 and the second frosted region 102 are each in a range of 80% to 90%. In some implementations, the light transmittances of the first frosted region 101 and the second frosted region 102 are each in a range of 85% to 90%.

In some implementations of the present disclosure, a roughness Ra of the first frosted region 101 is greater than a roughness Ra of the second frosted region 102. In some implementations, the roughness Ra of the first frosted region 101 is in a range of 1.5 µm to 4 µm. The roughness Ra of the second frosted region 102 is in a range of 0.3 µm to 1 µm. The first frosted region 101 having a relatively large roughness has an enhanced flashing effect, an enhanced anti-glare effect, and an obvious sense of touch, which enhances anti-fingerprint and anti-skidding effects. The second frosted region 102 having a relatively small roughness has an enhanced frosting effect, and has a fine and uniform flashing effect. Specifically, the surface roughness Ra of the first frosted region 101 may be, but is not limited to, 1.8 µm, 2 µm, 2.1 µm, 2.3 µm, 2.5 µm, 2.7 µm, 2.8 µm, 3 µm, 3.2 µm, 3.5 µm, 3.9 µm, or the like. The surface roughness Ra of the second frosted region 102 may be, but is not limited to, 0.4 µm, 0.45 µm, 0.5 µm, 0.6 µm, 0.7 µm, 0.8 µm, 0.9 µm, 0.95 µm, or the like. In some implementations, the surface roughness Ra of the first frosted region 101 is in a range of 2 µm to 3 µm. The roughness Ra of the second frosted region 102 is in a range of 0.45 µm to 0.8 µm. In some implementations, the surface roughness Ra of the second frosted region 102 is in a range of 0.45 µm to 0.6 µm.

An embodiment of the present disclosure further provides a method for preparing flashed glass, which may be used for preparing the flashed glass in any of the foregoing implementations.

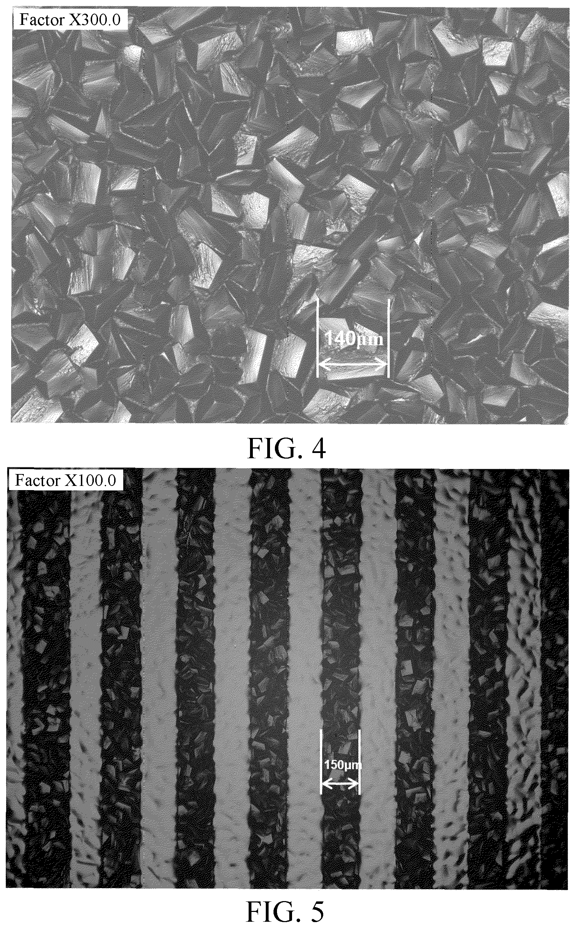

Referring to FIG. 3 and FIG. 4 together, the method for preparing flashed glass provided in the embodiments of the present disclosure includes the following steps S10, S20, and S30.

S10: First etching-by-frosting is performed on a first surface 10a of a glass body 10, to cause multiple first protruding structures 11 to be formed on the first surface 10, where each of the first protruding structures 11 includes at least one edge.

S20: Multiple photoresist patterns 20 in parallel and distributed spaced away are formed on the first surface 10a after the first etching-by-frosting, where the photoresist patterns 20 are long strip-shaped.

S30: Second etching-by-frosting is performed on the first surface 10a with the photoresist patterns 30, to cause multiple second protruding structures 12 (that is, second frosted regions 102 having multiple second protruding structures 12 are transformed) to be formed on the first surface not covered by the photoresist patterns 30, and then the photoresist patterns 30 are removed to obtain flashed glass. The first surface 10a of the flashed glass includes the second frosted region 102 and the first frosted region 101 having multiple first protruding structures 11. The first frosted region 101 and the second frosted region 102 are straight strip-shaped and distributed spaced away. Two adjacent first frosted regions 101 are connected by the second frosted region 102. Each of the second protruding structures 12 includes at least one edge. A height and a length of the second protruding structure 12 are both less than a height and a length of the first protruding structure 11.

In some implementations of the present disclosure, before the first etching-by-frosting is performed, the method may further include the following step. A protective layer is arranged on the surface of the glass body on which no etching-by-frosting is performed, to prevent contact with a frosting solution. For example, as shown in FIG. 3, an acid-resistant protective layer 20 may be arranged on a second surface 10b opposite to the first surface 10a of the glass body 10. Correspondingly, after the second etching-by-frosting in step S03 is completed, the acid-resistant protective layer 20 also needs to be removed. The acid-resistant protective layer 20 may be an acid-resistant polymer film (such as polyethylene terephthalate (PET)), or an ink layer. Optionally, a thickness of the acid-resistant protective layer 20 may range from 20 µm to 50 µm. The acid-resistant protective layer 20 may be removed by a physical removal method such as sanding and polishing, or a chemical removal method such as alkali etching.

In step S10, after the first etching-by-frosting, the first surface 10a is entirely frosted, is provided with multiple first protruding structures 11. In some implementations, the first surface 10a includes multiple first protruding structures 11 that are closely arranged. The first surface 10a in this case may be referred to as a "frosted surface".

The frosting solution (collectively referred to as a "first frosting solution" below) used for the first etching-by-frosting includes meta-aluminate, nitric acid, hydrochloric acid, sulfuric acid, ammonium hydrogen difluoride, and water. In some implementations, the first frosting solution further includes an organic acid.

In the foregoing first frosting solution, nitric acid, hydrochloric acid, and sulfuric acid are mainly configured to generate hydrogen ions to provide a strong acid environment. The ammonium hydrogen difluoride may etch a glass surface in the strong acid environment and form fluorosilicate ions with silicon elements in the glass. The fluorosilicate ions can combine with metal ions in the glass (such as Na⁺, K⁺, Li⁺, Mg²⁺, Al³⁺, and Ca²⁺) to form fluorosilicate. Slightly soluble or insoluble fluorosilicates build up and adhere to the glass surface through microcrystal nucleus growth, forming multi-angular masking crystals on the glass surface and hindering etching of the glass surface on which masking crystals are formed. A region to which no masking crystals adhere continues to be etched, and the frosting solution gradually etches inward along the periphery of the masking crystals. To be specific, the frosting solution etches along a contour of the masking crystal. After the etching-by-frosting is completed, the masking crystal adhering to the glass surface may be removed by a cleaning process, to obtain etched glass having multiple protruding structures on the surface, causing an original smooth and transparent surface of the glass body to have a frosting effect and a flashing effect. The meta-aluminate may be used to adjust a size and a distribution of the masking crystal of the fluorosilicate, and then may control a size and a distribution of the first protruding structure to adjust and control the frosting effect and the flashing effect of the glass surface. The hydrochloric acid and the sulfuric acid may be used to adjust a concentration of the hydrogen ions, thereby controlling a precipitation rate of crystals. Presence of the organic acid may stabilize acidity of the frosting solution, may improve dispersity of components of the frosting solution in a system to ensure that the frosting solution can be stored for a long time, and may also promote a uniform distribution of the fluorosilicate crystals on the glass surface, thereby ensuring uniformity of the distribution of the first protruding structure.

In some implementations of the present disclosure, the first frosting solution includes the following components: meta-aluminate, in an amount of 1-3 parts by weight; nitric acid, in an amount of 25-40 parts by weight; hydrochloric acid, in an amount of 1-3 parts by weight; sulfuric acid, in an amount of 0.5-1.5 parts by weight; ammonium hydrogen difluoride, in an amount of 20-40 parts by weight; organic acid, in an amount of 1-3 parts by weight; and water. In some implementations, the water contained in the first frosting solution may be in an amount of 10-30 parts by weight. An appropriate water content may not only ensure full dissolution of each component, but also enable the fluorosilicate generated during etching to be adsorbed onto the glass body and grow by crystallization, thereby playing a shielding role.

A content of the meta-aluminate in the first frosting solution is controlled to be within the foregoing small range, to cause a relatively large size of a fluorosilicate crystal formed during etching and then facilitate formation of a first protruding structure having a relatively large length and width. It may also be ensured that the fluorosilicate crystals are aggregated and deposited in an orderly manner on the glass surface and connected into sheets, thereby ensuring orderliness and tightness of the distribution of the first protruding structure. In addition, a content of the ammonium hydrogen fluoride is controlled to be within the foregoing range. A mass ratio of the ammonium hydrogen difluoride and the meta-aluminate is appropriate, which facilitates an orderly arrangement of the fluorosilicate crystals, and may also ensure that the ammonium hydrogen difluoride can be fully dissolved in the frosting solution without precipitation, so as not to affect crystallization of the fluorosilicate, resulting in a great difference in flashing effects at different positions on the glass surface.

Specifically, in the first frosting solution, the meta-aluminate may be in an amount of 1.1 parts, 1.2 parts, 1.5 parts, 1.8 parts, 2 parts, 2.5 parts, 2.8 parts, 3 parts, or the like by weight. The ammonium hydrogen difluoride may be in an amount of 22 parts, 25 parts, 30 parts, 32 parts, 35 parts, 38 parts, or the like by weight. The nitric acid may be in an amount of 25 parts, 27 parts, 30 parts, 32 parts, 35 parts, 38 parts, or the like by weight. The sulfuric acid may be in an amount of 0.8 parts, 1 part, 1.2 parts, 1.4 parts, or the like by weight. The hydrochloric acid or the organic acid may be each in an amount of 1.1 parts, 1.2 parts, 1.5 parts, 1.8 parts, 2 parts, 2.5 parts, 2.8 parts, 3 parts, or the like by weight. In some implementations, in the first frosting solution, the ammonium hydrogen difluoride may be in an amount of 30-38 parts by weight, and the nitric acid may be in an amount of 30-38 parts by weight.

The meta-aluminate may include at least one of magnesium meta-aluminate, sodium meta-aluminate, potassium meta-aluminate, and calcium meta-aluminate. In some implementations of the present disclosure, the meta-aluminate in the first frosting solution is the magnesium meta-aluminate. The frosting solution containing the magnesium meta-aluminate may ensure a large size of the fluorosilicate masking crystal during etching, which facilitates formation of a large-sized protruding structure on the glass surface. The organic acid may include at least one of tartaric acid, citric acid, sorbic acid, sulfamic acid, and maleic acid. In some implementations, the organic acid is the tartaric acid.

In an implementation of the present disclosure, the first etching-by-frosting may be performed statically at 25-30°C for 2-5 min. A standing condition facilitates uniform and stable adhesion and growth of the fluorosilicate crystals on the glass surface, so as to produce a uniform and effective masking effect. Specifically, a temperature for the first etching-by-frosting may be 25°C, 27°C, 28°C, 30°C, or the like. The first etching-by-frosting has a low requirement for the temperature, and the glass may be etched at a room temperature, which reduces process costs. Time for the first etching-by-frosting may be 2 min, 2.5 min, 3 min, 4 min, 4.5 min, or the like.

In step S20, the photoresist patterns 30 that are distributed spaced away may be formed by a photolithography process, which may specifically include the following steps.

S201: A photoresist layer is formed on a first surface after the first etching-by-frosting.

S202: The photoresist layer is exposed and developed to remove part of the photoresist layer to obtain multiple long strip-shaped photoresist patterns in parallel and distributed spaced away.

The photoresist layer may be formed by coating and drying, and an entire surface thereof covers the first surface of the glass body after the first etching-by-frosting. Optionally, a thickness of the photoresist layer (that is, a thickness of the photoresist pattern) ranges from 3 µm to 10 µm, which may specifically be 4 µm, 5 µm, 6 µm, 7 µm, 8 µm, 9 µm, or the like. In some implementations, the thickness ranges from 6 µm to 8 µm. A manner of coating may be brushing, spraying, scraping, or spin coating. A solvent in a photoresist for forming the photoresist layer may be volatilized by drying, to reduce fluidity thereof. Optionally, a drying process may be performed at a temperature ranging from 80-120°C, for example, 90°C, 100°C, and 110°C.

Photosensitive components in the photoresist layer may be cross-linked by exposure to form a cross-linked structure, so that a subsequently exposed region may be dissolved by a developing solution (when the photoresist is positive photoresist), or an unexposed region may be dissolved by the developing solution (when the photoresist is a negative photoresist). A manner of the exposure may be conventional exposure (irradiating the photoresist layer with ultraviolet light through a predetermined mask) or laser direct imaging (LDI). The LDI does not need to use a mask for exposure, but directly forms a required image by laser scanning, and the displayed image after development is refined and has various shapes.

The developing solution used for the development is usually an alkaline solution. Specifically, a solution of inorganic bases such as sodium hydroxide, potassium hydroxide, sodium carbonate, sodium bicarbonate, and ammonia water, and a solution of organic bases such as tetramethylammonium hydroxide (TMAH), trimethylamine, and triethanolamine may also be used. In some specific embodiments, the developing solution may be a KOH solution with an electrical conductivity ranging from 30 mS/cm to 50 mS/cm, or a TMAH solution with a concentration of 2.38%. In the development process, the developing solution may be sprayed onto a side of the glass body, or the glass body may be immersed in the developing solution. The time for the development may range from 2-10 min. In some implementations, after the developing, post-baking may also be performed to improve and cure the photoresist pattern and enhance adhesion and hardness thereof. The post-baking may be performed at a temperature ranging from 140-180°C (for example, 150°C or 160°C) for 20 min to 50 min (for example, 30 min or 45 min).

In the present disclosure, a projection of the photoresist pattern 30 on the second surface 10b of the glass body 10 is long strip-shaped. In an implementation of the present disclosure, a maximum cross-sectional width W₁ of the photoresist pattern 30 ranges from 100 µm to 500 µm, and a spacing W₂ between two adjacent photoresist patterns 30 ranges from 100 µm to 500 µm. The maximum cross-sectional width herein refers to a maximum transverse size of the photoresist pattern 30, and refers to a maximum width of a cross-section in an extending direction (that is, a width direction) perpendicular to the photoresist pattern 30, which is specifically a maximum distance between any two points on a contour line of an orthographic projection of the photoresist pattern on the second surface 10b of the glass body. The "spacing between two adjacent photoresist patterns 30" refers to a minimum distance between two points on the contour lines of the orthographic projections of the two adjacent photoresist patterns 30 on the glass body.

The maximum cross-sectional width and the spacing of the photoresist pattern 30 are controlled to be within the foregoing range, so that a first frosted region 101 and a second frosted region 102 with a large width and a large spacing may be formed through second etching-by-frosting, and it is ensured that the two frosted regions each have a relatively large number of protruding structures, to enrich the flashing effect of glass and enhance the anti-fingerprint effect. Specifically, W₁ and W₂ of the photoresist pattern 30 are each 100 µm, 110 µm, 130 µm, 140 µm, 150 µm, 200 µm, 300 µm, 400 µm, 500 µm, or the like.

In an implementation of the present disclosure, in step S30, the frosting solution (collectively referred to as a "second frosting solution" below) used for the second etching-by-frosting includes meta-aluminate, nitric acid, hydrochloric acid, sulfuric acid, ammonium hydrogen difluoride, and water. In some implementations, the first frosting solution further includes an organic acid. In an implementation of the present disclosure, a mass percentage of the meta-aluminate in the second frosting solution is greater than a mass percentage of the meta-aluminate in the frosting solution used for the first etching-by-frosting. In this way, it may be ensured that the first protruding structure formed by the first etching-by-frosting may be etched and transformed into a relatively large number of small protruding structures (that is, the second protruding structures) during the second etching-by-frosting.

In some implementations of the present disclosure, the second frosting solution includes the following components: meta-aluminate, in an amount of 5-10 parts by weight; nitric acid, in an amount of 25-40 parts by weight; hydrochloric acid, in an amount of 1-3 parts by weight; sulfuric acid, in an amount of 0.5-1.5 parts by weight; ammonium hydrogen difluoride, in an amount of 20-40 parts by weight; organic acid, in an amount of 1-3 parts by weight; and water. In some implementations, the water contained in the second frosting solution may be in an amount of 10-30 parts by weight. An appropriate water content may not only ensure full dissolution of each component, but also enable the fluorosilicate generated during etching to be precipitated smoothly from the frosting solution and adsorbed onto the glass body, thereby playing a shielding role.

A mechanism of action of the second frosting solution is the same as that of the first frosting solution described above. Details are not described herein again. A content of the meta-aluminate in the second frosting solution is controlled to be within the foregoing large range, so that a size of a fluorosilicate crystal formed during etching is small, that is, an area of a shield generated by a reaction is reduced, which facilitates formation of the second protruding structure having a small length and width, and causes a flash point on the glass surface to have a high brightness and a fine flashing effect.

The meta-aluminate in the second frosting solution may include at least one of magnesium meta-aluminate, sodium meta-aluminate, potassium meta-aluminate, and calcium meta-aluminate. In some implementations of the present disclosure, the meta-aluminate in the second frosting solution is the sodium meta-aluminate or the potassium meta-aluminate. The sodium meta-aluminate or the potassium meta-aluminate has high solubility, so that the frosting solution may have good stability, and when the sodium meta-aluminate is used, a particle size of the protruding structure formed by the frosting solution on the glass surface is smaller than that of the potassium meta-aluminate, and a flashing brightness of the glass surface is higher than that of the potassium meta-aluminate. In some specific embodiments, the meta-aluminate in the second frosting solution is the sodium meta-aluminate. Compared with the potassium meta-aluminate, an etching rate of frosting solution using the sodium meta-aluminate is slightly slow, which is conducive to formation of a protruding structure with a fine structure through etching, thereby reducing a probability that a structural collapse occurs when the first protruding structure 11 not covered by the photoresist pattern 30 is etched into the second protruding structure 12.

Specifically, in the second frosting solution, the meta-aluminate may be in an amount of 5 parts, 5.5 parts, 6 parts, 7 parts, 8 parts, 9 parts, 9.5 parts, 10 parts, or the like by weight. The ammonium hydrogen difluoride may be in an amount of 22 parts, 25 parts, 30 parts, 32 parts, 35 parts, 38 parts, or the like by weight. The nitric acid may be in an amount of 25 parts, 27 parts, 30 parts, 32 parts, 35 parts, 38 parts, or the like by weight. The sulfuric acid may be in an amount of 0.8 parts, 1 part, 1.2 parts, 1.4 parts, or the like by weight. The hydrochloric acid or the organic acid may be each in an amount of 1.1 parts, 1.2 parts, 1.5 parts, 1.8 parts, 2 parts, 2.5 parts, 2.8 parts, 3 parts, or the like by weight. In some implementations, in the second frosting solution, the ammonium hydrogen difluoride may be in an amount of 30-38 parts by weight, and the nitric acid may include be in an amount of 30-38 parts by weight.

Similar to the foregoing first etching-by-frosting, the second etching-by-frosting may be performed statically at 25-30°C for 2-5 min. A standing condition facilitates uniform and stable adhesion and growth of the fluorosilicate crystals on the glass surface, so as to produce a uniform and effective masking effect. Specifically, a temperature for the second etching-by-frosting may be 25°C, 27°C, 28°C, 30°C, or the like. The frosting solution has a low requirement for the temperature, and the glass may be etched at a room temperature, which reduces process costs. Time for the second etching-by-frosting may be 2 min, 2.5 min, 3 min, 4 min, 4.5 min, or the like.

In step S30, the first frosted region is formed by performing the first etching-by-frosting on the glass surface. The second frosted region is formed by successively performing the first etching-by-frosting and the second etching-by-frosting on the glass surface. In addition, the first frosted region 101 and the second frosted region 102 are made of the same material as the glass body 10.

During the second etching-by-frosting of step S30, the glass surface covered by the photoresist pattern 30 is hardly affected by the second etching-by-frosting, which indicates that the photoresist pattern 30 is resistant to acid etching. Therefore, the photoresist pattern may be removed by an alkaline solution. In some embodiments, a method for removing the photoresist pattern includes the following step. A strongly alkaline solution with a concentration of 8-20 wt% is used to perform ultrasonic stripping at 40-90°C for 2-8 minutes. A strong base may be NaOH or KOH.

In some implementations of the present disclosure, after the second etching-by-frosting in step S30 is completed, the glass body may also be strengthened. A specific process after the strengthening may be performed based on conventional techniques (such as an ion exchange method). Details are not described herein again. Therefore, a surface stress of the glass may be enhanced, and a mechanical strength thereof may be improved.

The method for preparing flashed glass provided in the foregoing embodiments of the present disclosure is simple and suitable for processing of glass bodies made of various materials, and has short overall preparation/processing time and low costs. A frosting surface on a side surface of the flashed glass made by the foregoing preparing method has two frosted regions alternately distributed. Each of the frosted regions is provided with two protruding structures of different sizes. The flashed glass has abundant flashing effects, strong appearance expression, and good anti-fingerprint and anti-glare effects.

In addition, the first frosted region 101 with the first protruding structure 11 and the second frosted region 102 with the second protruding structure 12 are made of the same material as the glass body. To be specific, the finally obtained flashed glass is integrally formed, which avoids problems that a diaphragm is easy to fall off and cannot produce a sparkling appearance effect for a long time as a result of the flashing effect caused by use of additional stacked diaphragms made of different materials from glass.

An embodiment of the present disclosure further provides an electronic device housing, which includes the flashed glass as described in the present disclosure, or includes the flashed glass made by the preparing method as described in the present disclosure.

The electronic device housing including the foregoing flashed glass has a cool appearance effect, which can improve the appearance expression of the electronic device and the product competitiveness.

In some implementations of the present disclosure, when the flashed glass of the present disclosure is applied to the electronic device housing, the flashed glass may also be coated with an anti-fingerprint film. For example, the anti-fingerprint film is arranged on the first surface with the first frosted region and the second frosted region.

In addition, the electronic device housing may further include a decorative layer arranged on the second surface 10b of the glass body 10 to satisfy a requirement for an appearance effect of the housing. Specifically, the decorative layer may include, but is not limited to, at least one of an optical film layer, a protective layer, and a cover bottom ink layer.

The foregoing electronic device housing may be a display screen cover plate, a rear cover, a middle frame of the electronic device, or a composite housing in which the rear cover and the middle frame are integrally formed. The electronic device using the foregoing electronic device housing may be various consumer electronics, such as a mobile phone, a tablet computer, a laptop, and a wearable device (such as a smart watch and a smart bracelet), and an electronic device such as a virtual reality (VR) terminal device, an augmented reality (AR) terminal device, an e-reader, a television, a camcorder, and a projector.

An example in which the electronic device is a portable electronic device such as a mobile phone, a tablet computer, and a wearable product is used. The electronic device housing may be a display screen cover plate arranged on a front side of the electronic device, which is arranged on a display module. The electronic device housing may also be a rear cover arranged on a rear side of the electronic device. In some implementations, when the electronic device is an electronic device (such as a mobile phone and a digital camera) having a photographing function, the electronic device housing may also be a cover plate for protecting a camera.

Technical solutions of the present disclosure continue to be described below through specific embodiments.

### Embodiment 1

A method for preparing flashed glass is provided. For a preparation process, reference may be made to FIG. 3. The method includes the following steps.
(1) A first frosting solution is prepared. Tartaric acid (C₄H₆O₆) and ammonium hydrogen difluoride (NH₄HF₂) are uniformly mixed. Nitric acid is added with stirring, and stirring is performed till uniform mixing. Hydrochloric acid, water, and magnesium meta-aluminate (Mg(AlO₂)₂) are successively added, and stirring is performed. Finally, sulfuric acid is added, and stirring is performed till uniform mixing. Standing is allowed for 4h, to give the first frosting solution. The first frosting solution includes the following components: magnesium meta-aluminate, in an amount of 2% by mass; nitric acid, in an amount of 36% by mass; hydrochloric acid, in an amount of 2% by mass; sulfuric acid, in an amount of 1% by mass; ammonium hydrogen difluoride, in an amount of 36% by mass; tartaric acid, in an amount of 2% by mass; and water in an amount of 21% by mass.

A glass body with a thickness of 0.6 mm (which is specifically a lithium aluminum silicate glass plate with a brand name of Panda-1681). First, a side surface (which may be referred to as a "back side") of the glass body is coated with an acid-resistant ink layer with a thickness of 35 µm. The glass body is immersed in the foregoing first frosting solution and allowed to stand at 25°C for 2 min, so that another surface (which may be referred to as a "front side" or a "first surface") arranged opposite the back side of the glass body is etched. Then the glass body is taken out and cleaned with clean water to obtain a glass body after first etching-by-frosting (as shown in FIG.4). Multiple first protruding structures including at least one edge are formed on the front side of the glass body (which may be referred to as "large sand-shaped protrusions"). The front side is changed from an original smooth surface to a frosted surface, which may be referred to as a "frosted surface".

(2) Photoresist patterns are formed on the surface after the first etching-by-frosting.

A photoresist layer with a thickness of about 7 µm is coated on the foregoing frosted surface, and baked in an oven at 100°C for 4 min to dry photoresist. Then exposure is performed through the LDI. Exposure patterns are linear strip patterns with a width of 150 µm, and the exposure patterns are spaced apart from each other by a spacing of about 165 µm. Next, a KOH solution with an electrical conductivity of 50 mS/cm (a mass concentration of 12 wt%) is used for immersion and development for 3 min to remove photoresist in an exposed region. Finally, the photoresist is post-baked in an oven at 150°C for 30 min to continue curing the photoresist. In this way, multiple long strip-shaped photoresist patterns in parallel and distributed spaced away appear on the frosted surface, as shown in FIG. 5.

(3) Second etching-by-frosting
A second frosting solution is prepared. Ammonium hydrogen difluoride and nitric acid are uniformly mixed. Tartaric acid is added with stirring, and stirring is performed till uniform mixing. Hydrochloric acid, water, and sodium meta-aluminate (NaAlO₂) are successively added, and stirring is performed. Finally, sulfuric acid is added, and stirring is performed till uniform mixing. Standing is allowed for 4h, to give the second frosting solution. The second frosting solution includes the following components: sodium meta-aluminate, in an amount of 7% by mass; nitric acid, in an amount of 37% by mass; hydrochloric acid, in an amount of 2% by mass; sulfuric acid, in an amount of 1% by mass; ammonium hydrogen difluoride, in an amount of 32% by mass; tartaric acid, in an amount of 2% by mass; and water in an amount of 19% by mass.

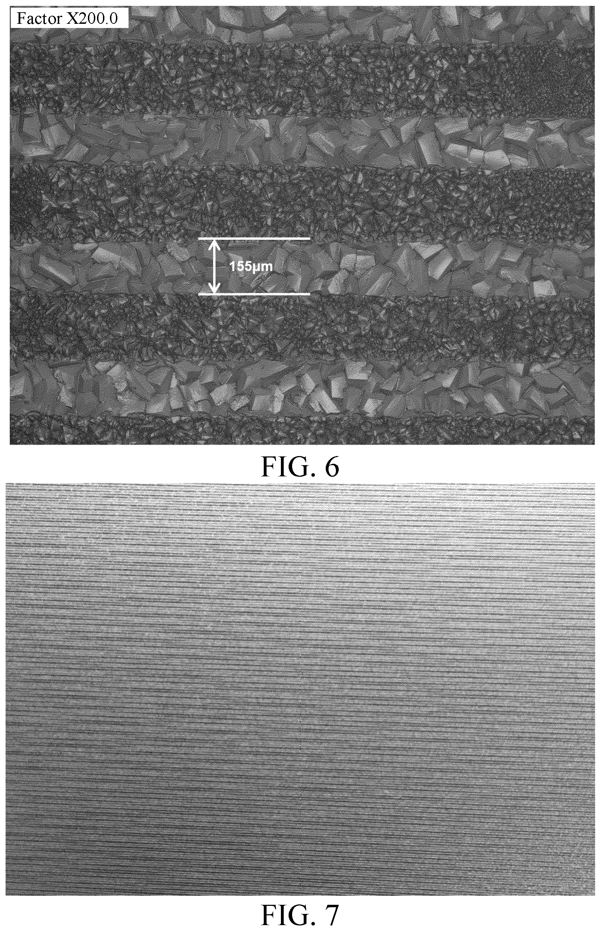

The foregoing glass body is immersed in the second frosting solution and allowed to stand at 25°C for 2 min, to perform the second etching-by-frosting on a frosted surface region not covered by the photoresist pattern to form multiple second protruding structures (as shown in FIG. 6, which may be referred to as "small sand-shaped protrusions"). Then the glass body is taken out and cleaned with clean water, and then the photoresist pattern and the foregoing acid-resistant ink layer are removed (a specific removal manner is performing ultrasonic stripping at 80°C for 10 min using an NaOH solution of 20 wt% and cleaning the glass body with clean water) to obtain the flashed glass shown in FIG. 6 and FIG. 1.

FIG. 1 and FIG. 6 show metallographic microscope photos of the flashed glass obtained in Embodiment 1 at different zoom-in factors. It may be learned from FIG. 1 and FIG. 6 that a side surface of the flashed glass includes the first frosted region 101 having multiple first protruding structures (large sand-shaped protrusions) and the second frosted region 102 having multiple second protruding structures (small sand-shaped protrusions). The first frosted region 101 and the second frosted region 102 are straight strip-shaped and distributed spaced away. Two adjacent first frosted regions 101 are connected by the second frosted region 102. A height and a length of the second protruding structure are both less than a height and a length of the first protruding structure. A width of the first frosted region 101 ranges from 140 µm to 165 µm. A width of the second frosted region 102 ranges from 150 µm to 180 µm.

It may also be learned from FIG. 1, FIG. 4, and FIG. 6 that the length of the large sand-shaped protrusion formed by the first etching-by-frosting ranges from 120 µm to 140 µm, and the height ranges from 10 µm to 16 µm. It may be learned from FIG. 6 and FIG. 1 that the length of the small sand-shaped protrusion formed by the second etching-by-frosting ranges from 30 µm to 60 µm, and the height ranges from 3 µm to 6 µm.

In addition, after step (1), the haze, the light transmittance, and the roughness of the glass body after the first etching-by-frosting shown in FIG. 4 are also tested to obtain relevant results of the first frosted region. The second etching-by-frosting is directly performed on the glass in FIG. 4 without photoresist shielding, to obtain frosted glass with small sand-shaped protrusions on the surface. The haze, the light transmittance, and the roughness of the glass are tested to obtain relevant results of the second frosted region. Certainly, roughness parameters of the first frosted region and the second frosted region may also be obtained by directly testing the glass of FIG. 1 or FIG. 6.

The haze and the light transmittance are measured by a BYK transmission haze meter BYK-4725 from Germany, and the roughness is measured by an SJ411 surface roughometer. For test results, reference is made to Table 1 below. Roughness characterization parameters include Rₐ, R_{z}, and Rₜ, where Rₐ represents an arithmetic mean, R_{z} represents an average of depths of a peak and a valley, and Rt represents a sum of a maximum value of a profile peak and a minimum value of a profile valley.

**Table 1**

| Embodiment 1 | Haze (%) | Light transmittance (%) | Roughness (µm) | | |
|---|---|---|---|---|---|
| | | | Rₐ | R_{z} | Rₜ |
| First frosted region | 85.2 | 88.6 | 2.164 | 12.362 | 15.337 |
| Second frosted region | 92.6 | 88.8 | 0.563 | 4.297 | 5.770 |

It may be learned from Table 1 that a side surface of the glass is provided with two frosted regions with different roughnesses. The frosted regions each have a relatively high haze and a relatively high light transmittance, have a hazy visual effect and good transparency, and have strong appearance expression.

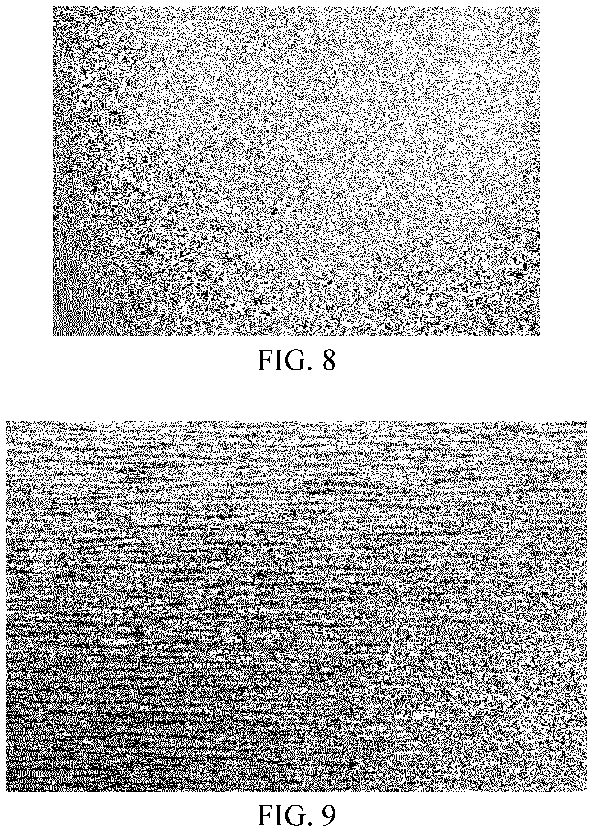

In addition, the flashed glass of Embodiment 1 of the present disclosure is photographed to obtain an appearance effect diagram thereof, as shown in FIG. 7. Moreover, the glass body (that is, the glass of FIG. 4) after the first etching-by-frosting is also photographed during preparation of the flashed glass of Embodiment 1, and an appearance effect diagram thereof is shown in FIG. 8. The foregoing appearance effect diagram specifically refers to a visual effect presented by the glass on a macro scale.

It may be learned from FIG. 7 and FIG. 8 that after the first etching-by-frosting is performed on the glass body, a surface thereof has a specific flashing effect, but has a single flashing effect. The flashed glass made by the method of the embodiment of the present disclosure has an obvious flashing effect, and has multiple flashing effects with different flash degrees. A region with small protrusions has a fine sparkle due to smaller sizes and a large number of protruding structures, which may be referred to as having a fine flashing effect.

### Embodiment 2

A method for preparing flashed glass is provided, which is different from Embodiment 1 in that the sodium meta-aluminate in the second frosting solution is replaced with the magnesium meta-aluminate, that is, the first frosting solution and the second frosting solution contain the same type of meta-aluminate.

### Embodiment 3

A method for preparing flashed glass is provided, which is different from Embodiment 1 in the following. 1) The first frosting solution includes the following components: magnesium meta-aluminate, in an amount of 3% by mass; nitric acid, in an amount of 37% by mass; hydrochloric acid, in an amount of 1% by mass; sulfuric acid, in an amount of 0.5% by mass; ammonium hydrogen difluoride, in an amount of 38% by mass; tartaric acid, in an amount of 2.5% by mass; and water in an amount of 18% by mass.

2) The second frosting solution includes the following components: sodium meta-aluminate, in an amount of 10% by mass; nitric acid, in an amount of 39% by mass; hydrochloric acid, in an amount of 2% by mass; sulfuric acid, in an amount of 1% by mass; ammonium hydrogen difluoride, in an amount of 35% by mass; tartaric acid, in an amount of 3% by mass; and water in an amount of 10% by mass.

### Embodiment 4

A method for preparing flashed glass is provided, which is different from Embodiment 1 in the following. 1) The first frosting solution includes the following components: magnesium meta-aluminate, in an amount of 1% by mass; nitric acid, in an amount of 32% by mass; hydrochloric acid, in an amount of 2% by mass; sulfuric acid, in an amount of 1% by mass; ammonium hydrogen difluoride, in an amount of 32% by mass; tartaric acid, in an amount of 2% by mass; and water in an amount of 30% by mass.

2) The second frosting solution includes the following components: potassium meta-aluminate, in an amount of 5% by mass; nitric acid, in an amount of 35% by mass; hydrochloric acid, in an amount of 2% by mass; sulfuric acid, in an amount of 1% by mass; ammonium hydrogen difluoride, in an amount of 30% by mass; tartaric acid, in an amount of 2% by mass; and water in an amount of 25% by mass.

### Embodiment 5

A method for preparing flashed glass is provided, which is different from Embodiment 1 in the following. In step (2), a maximum cross-sectional width of photoresist patterns is about 400 µm, and a spacing between adjacent photoresist patterns is about 450 µm.

A main difference between the flashed glass made in Embodiment 5 and that in Embodiment 1 is that the first frosted region and the second frosted region have different widths. The width of the first frosted region of the flashed glass obtained in Embodiment 5 is in a range of 390 µm to 420 µm, and the width of the second frosted region is in a range of 450 µm to 480 µm.

FIG. 9 is an appearance effect diagram of flashed glass according to Embodiment 5 of the present disclosure. It may be learned from FIG. 9 that the two frosted regions are easier to be distinguished with naked eyes compared with those of Embodiment 1 since the widths of the two frosted regions are wider than those of Embodiment 1. A deeper region is the second frosted region having small protrusions, which has a finer flashing effect than the first frosted region.

Dimension parameters of the protruding structures of the flashed glass in Embodiment 2 to Embodiment 4 are summarized in Table 2 below. Test results of the haze, the light transmittance, and the roughness of the flashed glass in Embodiment 2 to Embodiment 5 are summarized in Table 3 below.

**Table 2**

| Experimental group | Large sand-shaped protrusion | | Small sand-shaped protrusion | |
|---|---|---|---|---|
| | Length range (µm) | Height range (µm) | Length range (µm) | Height range (µm) |
| Embodiment 2 | 125-140 | 12-14 | 40-60 | 4-6 |
| Embodiment 3 | 100-125 | 10-14 | 30-45 | 3-4.5 |
| Embodiment 4 | 125-150 | 14-16 | 45-60 | 4.5-6 |
| Embodiment 5 | 125-140 | 12-14 | 30-60 | 3-6 |

**Table 3**

| Experimental group | | Haze (%) | Light transmittance (%) | Roughness (µm) | | |
|---|---|---|---|---|---|---|
| | | | | Rₐ | R_{z} | Rₜ |
| Embodiment 5 | First frosted region | 85.3 | 88.1 | 2.165 | 12.360 | 15.335 |
| | Second frosted region | 92.5 | 89.0 | 0.562 | 4.296 | 5.771 |
| Embodiment 2 | First frosted region | 83.7 | 88.5 | 2.159 | 12.42 | 15.401 |
| | Second frosted region | 94.9 | 87.7 | 0.583 | 4.728 | 5.967 |
| Embodiment 3 | First frosted region | 89.8 | 85.6 | 2.085 | 12.120 | 15.101 |
| | Second frosted region | 95.0 | 85.0 | 0.492 | 4.56 | 5.51 |
| Embodiment 4 | First frosted region | 80.3 | 89.5 | 2.87 | 12.834 | 15.861 |
| | Second frosted region | 93.5 | 88.8 | 0.589 | 4.871 | 5.973 |

It may be learned from Table 3 that the surface of the flashed glass of the foregoing embodiments of the present disclosure is provided with two frosted regions with different roughnesses, and the frosted regions each have a high haze and an appropriate light transmittance, which indicates that the flashed glass in the embodiments of the present disclosure has a good frosting effect and good transparency and can implement a special appearance effect. In addition, the two frosted regions with different roughnesses may also provide the flashed glass with abundant and dynamic flashing effects and a good anti-glare effect and anti-fingerprint effect.

In addition, it may be learned through comparison between Embodiment 1 and Embodiment 2 that when the first frosting solution and the second frosting solution have different types of meta-aluminate, compared with the first frosted region formed by the first etching-by-frosting, the small protruding structures of the second frosted region formed by the second etching-by-frosting are arranged more closely, have a smaller roughness Ra, and a higher haze.

The foregoing descriptions express several exemplary implementations of the present disclosure only. The descriptions thereof are relatively specific and detailed, but cannot be understood as limitations to the patent scope of the present disclosure. It should be noted that for a person of ordinary skill in the art, several transformations and improvements can be made without departing from the idea of the present disclosure. These transformations and improvements shall fall within the protection scope of the present disclosure.

In the drawings:
10: Glass body;
10a: First surface;
101: First frosted region;
102: Second frosted region;
11: First protruding structure;
12: Second protruding structure;
10a: First surface;
10b: Second surface.

## Claims

1. Flashed glass, comprising a glass body (10), the glass body (10) being provided with a first surface (10a), the first surface (10a) comprising a plurality of first frosted regions (101) distributed spaced away, two adjacent first frosted regions (101) being connected by a second frosted region (102), and the first frosted regions (101) and the second frosted region (102) are straight strip-shaped, wherein each of the first frosted regions (101) has a plurality of first protruding structures (11), the second frosted region (102) has a plurality of second protruding structures (12), each of the first protruding structures (11) and each of the second protruding structures (12) respectively comprise at least one edge, and a height and a length of the second protruding structure (12) are both less than a height and a length of the first protruding structure (11).

2. The flashed glass according to claim 1, wherein shapes of the first protruding structure (11) and the second protruding structure (12) each comprise at least one of a prism, a pyramidal frustum, a cube, and a pyramid.

3. The flashed glass according to claim 1 or 2, wherein the length of the first protruding structure (11) is in a range of 100 µm to 150 µm; and the height of the first protruding structure (11) is in a range of 10 µm to 16 µm.

4. The flashed glass according to any of claims 1 to 3, wherein the length of the second protruding structure (12) is in a range of 30 µm to 60 µm; and the height of the second protruding structure (12) is in a range of 3 µm to 6 µm.

5. The flashed glass according to any of claims 1 to 4, wherein a width of the first frosted region (101) is in a range of 100 µm to 500 µm; and a width of the second frosted region (102) is in a range of 100 µm to 500 µm.

6. The flashed glass according to any of claims 1 to 5, wherein a haze of the first frosted region (101) is in a range of 80% to 90%; a light transmittance is in a range of 75% to 93%; a haze of the second frosted region (102) is in a range of 90% to 95%; and a light transmittance is in a range of 75% to 93%.

7. The flashed glass according to any of claims 1 to 5, wherein a roughness Ra of the first frosted region (101) is in a range of 1.5 µm to 4 µm; and a roughness Ra of the second frosted region (102) is in a range of 0.3 µm to 1 µm.

8. A method for preparing flashed glass, comprising the following steps:
performing first etching-by-frosting on a first surface (10a) of a glass body (10), to cause a plurality of first protruding structures (11) to be formed on the first surface (10a), wherein each of the first protruding structures (11) comprises at least one edge;
forming a plurality of photoresist patterns in parallel and distributed spaced away on the first surface (10a) after the first etching-by-frosting, the photoresist patterns being long strip-shaped; and
performing second etching-by-frosting on the first surface (10a) with the photoresist patterns, to cause the first surface (10a) not covered by the photoresist patterns to be transformed into a second frosted region (102) having a plurality of second protruding structures (12), then removing the photoresist patterns, and obtaining a first frosted region (101) having the plurality of first protruding structures (11) on a surface between adjacent second frosted regions (102),
wherein each of the second protruding structures (12) comprises at least one edge; and a height and a length of the second protruding structure (12) are both less than a height and a length of the first protruding structure (11).

9. The preparing method according to claim 8, wherein frosting solutions used for the first etching-by-frosting and the second etching-by-frosting each comprise meta-aluminate, nitric acid, hydrochloric acid, sulfuric acid, ammonium hydrogen difluoride, and water; and a mass percentage of the meta-aluminate in the frosting solution used for the second etching-by-frosting is greater than a mass percentage of the meta-aluminate in the frosting solution used for the first etching-by-frosting.

10. The preparing method according to claim 9, wherein
the frosting solution used for the first etching-by-frosting comprises the following components: meta-aluminate, in an amount of 1-3 parts by weight; nitric acid, in an amount of 25-40 parts by weight; hydrochloric acid, in an amount of 1-3 parts by weight; sulfuric acid, in an amount of 0.5-1.5 parts by weight; ammonium hydrogen difluoride, in an amount of 20-40 parts by weight; tartaric acid, in an amount of 1-3 parts by weight; and water;
the frosting solution used for the second etching-by-frosting comprises the following components: meta-aluminate, in an amount of 5-10 parts by weight; nitric acid, in an amount of 25-40 parts by weight; hydrochloric acid, in an amount of 1-3 parts by weight; sulfuric acid, in an amount of 0.5-1.5 parts by weight; ammonium hydrogen difluoride, in an amount of 20-40 parts by weight; tartaric acid, in an amount of 1-3 parts by weight; and water.

11. The preparing method according to claim 9 or 10, wherein the meta-aluminate comprises at least one of magnesium meta-aluminate, sodium meta-aluminate, potassium meta-aluminate, and calcium meta-aluminate.

12. The preparing method according to claim 9 or 10, wherein the meta-aluminate in the frosting solution used for the first etching-by-frosting is magnesium meta-aluminate; and the meta-aluminate in the frosting solution used for the second etching-by-frosting is sodium meta-aluminate or potassium meta-aluminate.

13. The preparing method according to any of claims 8 to 12, wherein the first etching-by-frosting is performed statically at 25-30°C for 2-5 min; and the second etching-by-frosting is performed statically at 25-30°C for 2-5 min.

14. An electronic device housing,
comprising the flashed glass according to any of claims 1 to 7, or
comprising the flashed glass made by the preparing method according to any of claims 8 to 13.
